# EUROPEAN PATENT APPLICATION

(11) **EP 2 343 623 A1**
(43) Date of publication of application: **13.07.2011**
(21) Application number: 10173810.2
(22) Date of filing: 24.08.2010
(51) Int. Cl.: G06F 1/18

(54) **Cover detaching and attaching structure and electronic device using the same**

(30) Priority: 29.12.2009 JP 2009299172
(71) Applicant: Toshiba TEC Kabushiki Kaisha, Tokyo 141-8664 (JP)
(72) Inventor: Nishihashi, Kiyotaka, Shinagawa-ku Tokyo 141-8664 (JP)
(74) Representative: Gendron, Vincent Christian

(57) **Abstract**

According to one embodiment, a cover detaching and attaching structure allows a cover (13) including a through part (17), through which a power cord (15) connected to a connection part (16) passes, to be integrally engaged with a main body (12) including the connection part (16) for the power cord (15) and to be arbitrarily removed from the main body (12) in a state in which the power cord (15) has passed through the through part (17). The cover detaching and attaching structure is arranged between the main body (12) and the cover (13), to allow the cover (13) to move in a first direction (B) along the longitudinal direction of the power cord (15) connected to the connection part (16) from a state of being integrally engaged with the main body (12).

## Description

### FIELD

Embodiments described herein relate generally to a cover detaching and attaching structure to allow a cover including a through part for passing a power cord connected to a connection part to be integrally engaged with a main body including the connection part for the power cord, and to be arbitrarily removed from the main body in a state in which the power cord has passed through the through part, and an electronic device using the cover detaching and attaching structure.

### BACKGROUND

In general, an electronic device used in an information system such as a Point-of-Sales (POS) system includes a main body case configured to accommodate a variety of electronic instruments, and a cover integrally attached to the main body case and configured to cover the main body case. In the electronic device, since the cover can be easily attached to or detached from the main body even with a power cord connected to a power supply, there is a risk that a maintenance worker may get an electric shock or inadvertently damage the device.

Thus, there has been proposed a structure to turn off a power supply when a part of the device is opened to replace and add a board (e.g., PCB), thereby avoiding the electric shock and the damage to a board.

In the above structure of the related art, an AC inlet of the power supply is provided at a rear side of a main body of the device to allow a power cord to be inserted into the AC inlet. Since a part of a lower cover to be attached to the main body is formed to surround the periphery of the AC inlet, the lower cover cannot be detached from the main body with the power cord inserted into the AC inlet.

In the above related art, although detachment of the lower cover from the main body is taken into consideration, the lower cover covers only a part of a power-applied portion and other portions are exposed to the outside irrespective of whether the power cord is connected thereto. Thus, such structure is not sufficient to prevent the risk of electric shock and damage of parts.

In addition, since the lower cover is detached from the main body only through one-way movement in which the lower cover is spaced apart from the main body upon removal of the lower cover from the main body, it can also be freely removed from the main body even when the power cord has been removed from the AC inlet. In case of adopting the above cover detaching and attaching structure as an attachment and detachment structure of a cover for covering a main body having a charge portion, if the cover has, for example, a rectangular parallel pipe shape, it may be required that at least four points near four corners of the cover should be fixed to the main body by means of screws in order to integrally fix the cover to the main body in a normal use. In this case, since the number of screw fixing portions increase, the attachment and detachment of the cover to and from the main body is complicated, for which much work time is needed.

### BRIEF DESCRIPTION OF THE DRAWINGS

**FIG 1** is a perspective view showing an external appearance of an electronic device.

**FIG. 2** is a partial perspective view showing a state in which a power cord is connected to a power inlet when a cover is engaged with a main body in the electronic device.

**FIG. 3** is a partial perspective view showing a state in which the cover is moved in a first direction with respect to the state in which a power cord is connected to a power inlet in the electronic device.

**FIG. 4** is an internal view of the electronic device showing a state in which the cover is moved in a first direction with respect to the state in which a power cord is connected to a power inlet in the electronic device.

**FIG. 5** is a partial perspective view of the cover detaching and attaching structure in an engaged state in which the cover is engaged with the main body.

**FIG. 6** is a partial perspective view of the cover detaching and attaching structure in a state in which the cover is moved in a first direction.

**FIG. 7** is a partial exploded perspective view of an engagement portion.

### DETAILED DESCRIPTION

According to one embodiment, a cover detaching and attaching structure allows a cover including a through part, through which a power cord connected to a connection part, to be integrally engaged with a main body including the connection part for the power cord and to be arbitrarily removed from the main body in a state in which the power cord has passed through the through part. The cover detaching and attaching structure is arranged between the main body and the cover, to allow the cover move in a first direction along the longitudinal direction of the power cord connected to the connection part from a state of being integrally engaged with the main body. The cover is further allowed to be moved in a second direction, thereby being detached from the main body, the second direction being orthogonal to the first direction in which the movement of the cover is impeded by interference of the power cord connected to the connection part.

Embodiments of a cover detaching and attaching structure and an electronic device using the cover detaching and attaching structure will now be described in detail with reference to the drawings.

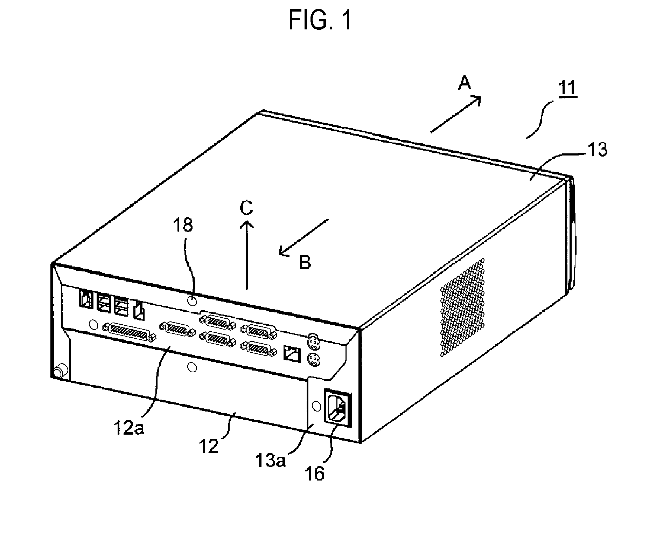

**FIGS. 1 to 3** show an external view of an electronic device for use in an information system such as a Point-of-Sales (POS) system according to one embodiment. The electronic device 11 includes a main body 12 having a box shape which is opened at the top surface thereof, and a cover 13 configured to cover a part of a rear surface 12a (a surface at the front side in **FIG. 1****;** hereinafter, also referred to as "main body rear surface portion"), both side surfaces, and the opened top surface.

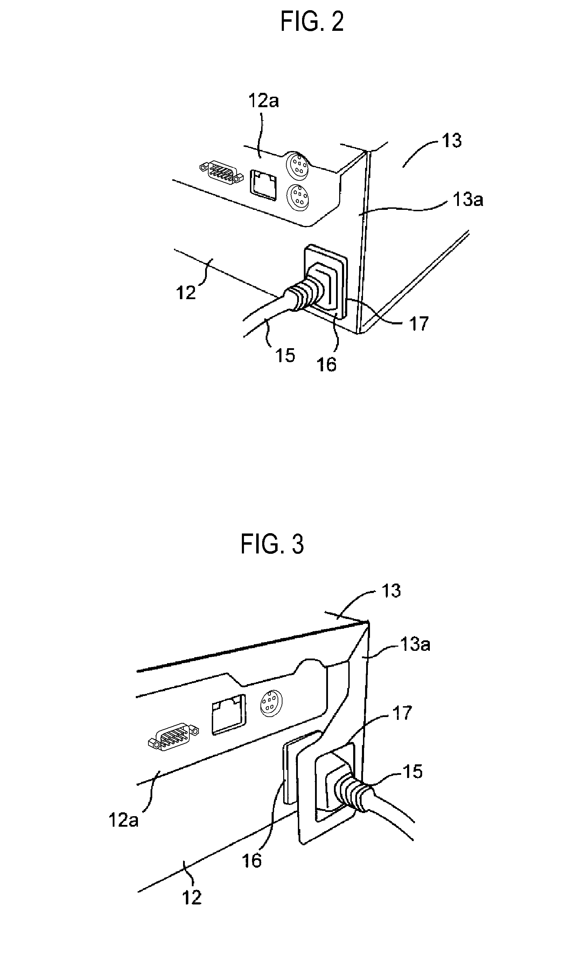

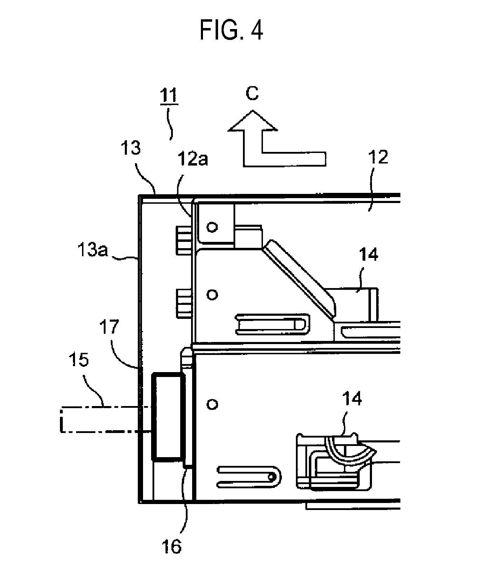

The main body 12 includes a variety of electronic units 14 for implementing certain functions of the electronic device 11 as shown in **FIG. 4****.** Also, a connection part 16 (hereinafter, also referred to as "power inlet") into which a plug unit at a front end of a power cord 15 is inserted is provided at the rear surface 12a of the main body 12, as shown **FIGS. 2 and 3****.** In addition, a switch or a terminal for connection with external elements is arranged at the rear surface 12a of the main body 12, and a plurality of vent holes are formed at the surface of the main body 12.

As described above, the cover 13 is configured to cover a part of the rear surface 12a, both side surfaces, and the top surface of the main body 12. Among these portions, a cover portion covering a part of a rear surface 12a of the main body 12 includes a portion that covers an upper edge portion and left and right side portions of the main body rear surface portion 12a. This cover portion is called a cover rear surface portion 13a. A through part 17 for passage of the power cord 15 connected to the power inlet 16 is formed on a surface that opposes the power inlet 16 in the cover rear surface portion 13a shown in a right side of **FIG, 2 and 3****.** The passage area of the through part 17 is determined to allow a plug unit having a large diameter at the front end of the power cord 15 to pass therethrough.

In one embodiment, provided between the cover 13 and the main body 12 is a cover detaching and attaching structure that can integrally attach the cover 13 to the main body 12, and arbitrarily detach the cover 13 from the main body 12. A detailed description of the cover detaching and attaching structure will be made later. The cover detaching and attaching structure is configured to allow the cover 13 to move slidably within a predetermined range forward and backward (i.e., in the directions of arrows "A" and "B" in **FIG. 1**) with respect to the main body 12. In **FIG. 1****,** the cover 13 advances, i.e., is moved forward within a given range in the direction of the arrow "A" so that a front edge of the cover 13 substantially overlaps with a front edge of the main body 12. In this state, the cover 13 is integrally engaged with the main body 12 by the cover detaching and attaching structure, as will be described later. Accordingly, the cover 13 can be fixed to the main body 12, e.g., by means of a screw 18 (e.g., only one screw) that is secured between the cover rear surface portion 13a and the main body rear surface 12a.

When removing the cover 13 from the main body 12, after one screw 18 is removed, the cover 13 retracts, i.e., is moved backward within a determined range in the direction of the arrow "B" of **FIG. 1** with respect to the main body 12. The direction of backwards movement of the cover 13 is a direction extending along the longitudinal direction of the power cord 15 connected to the connection part 16 of the main body 12. This backward direction is called a first direction "B." In some embodiments, the power cord 14 has a plug unit having a structure to limit the range of retraction of the cover 13. For example, the plug unit of the power cord 14 has a latch shape to interfere with the retraction of the cover 13 to thereby prevent the cover 13 from moving backward more than a predetermined distance along the first direction B. By way of this retraction operation of the cover 13, the cover 13 which is in close contact with the main body rear surface 12a as shown in **FIG. 2** is spaced away from the main body rear surface 12a by a distance corresponding to the retraction distance of the cover 13 as shown in **FIGS. 3** **and** **4****.** Further, the retraction operation allows the cover 13 to be released from the state in which the cover 13 has been engaged with the main body 12 through the cover detaching and attaching structure, which will be described later. Thereafter, the cover 13 is moved upward (i.e., in the direction of an arrow "C" of **FIG. 1**) to cause the cover 13 to be removed or detached from the main body 12. For example, the direction of upward movement of the cover 13 is orthogonal to the first direction "B." This upward direction is called a second direction "C."

At this time, in a state where the power cord 15 has been connected to the power inlet 16 of the main body 12, since the power cord 15 passes through the through part 17 penetratingly formed in the cover rear surface portion 13a as shown in **FIGS. 3** **and** **4****,** the power cord 15 impedes the cover 13 from moving upward. In this way, the cover 13 can be prevented from being removed from the main body 12 in a state in which the power cord 15 is electrically connected to the power inlet 16 and electric power is supplied to the inside of the main body 12, thereby making it possible to safely protect a maintenance worker from getting an electric shock causing an accident.

In other words, to detach the cover 13 from the main body 12, the cover detaching and attaching structure arranged between the main body 12 and the cover 13 is configured to first allow the cover 13 to move in the first direction "B" along the longitudinal direction of the power cord 15 connected to the connection part 16 to release the cover 13 from its engaged state with the main body 12. Then, the cover 13 that is moved in the first direction "B" is further moved in the second direction "C" which is substantially orthogonal to the first direction "B," so that the cover 13 can be removed from the main body 12. If the power cord 15 is connected to the connection part 16, the cover 13 is impeded from moving into the second direction "C" by interference between the power cord 15 and the cover 13, thereby preventing removal of the cover 13 from the main body 12.

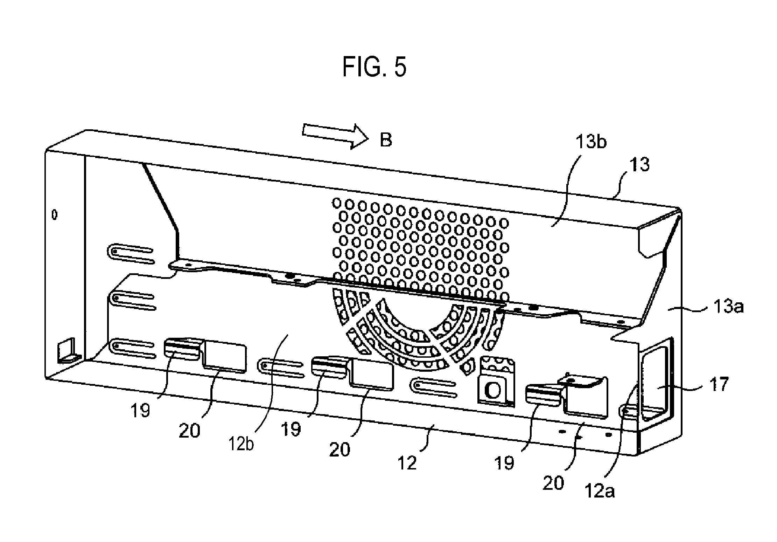

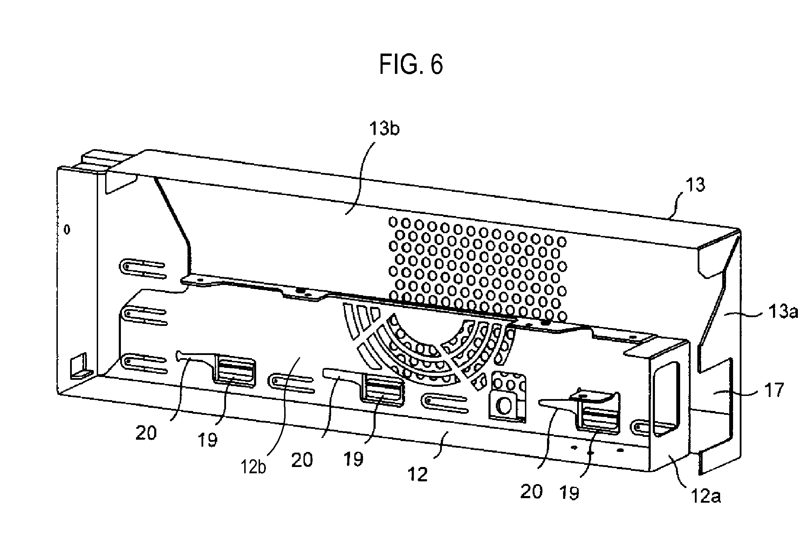

Next, the detailed construction of the above-mentioned cover detaching and attaching structure will be described with reference to **FIGS. 5 to 7****.** In **FIGS. 5** **and** **6****,** a reference numeral 13b denotes a side surface of the cover 13 (hereinafter, referred to as "cover side surface portion"), and a reference numeral 12b denotes a side surface of the main body 12 (hereinafter, referred to as "main body side surface portion"). These side surface portions are configured to be joined to each other and to move slidably with respect to each other in the forward and backward directions (i.e., in the first and second directions "A" and "B").

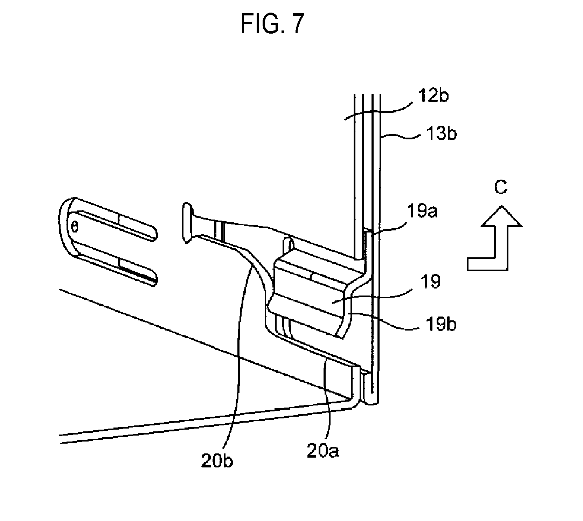

A plurality of engagement pieces 19 (e.g., 3 engagement pieces shown in the drawings) are provided on the inner surface of the cover side surface portion 13b, i.e., on the joining surface between the cover side surface portion 13b and the main body side surface portion 12b. As shown in **FIG. 7****,** each of the engagement pieces 19 has a Z-shape in cross section. One segment 19a of the engagement piece 19 is integrally joined to the inner surface of the cover side surface portion 13b, and other segment 19b of the engagement piece 19 defines an engagement groove that opens downward between the other segment 19b and the inner surface of the cover side surface portion 13b. The spacing of the engagement groove is set to be slightly larger than the thickness of the main body side surface portion 12b.

Meanwhile, the main body side surface portion 12b has a plurality of engagement parts 20 formed thereon so as to be engaged with the engagement pieces 19. As shown in **FIG. 7****,** each of the engagement parts 20 includes an aperture 20a having an area sized to allow the other segment 19b to be loosely fitted into the aperture 20a, and a slit 20b extending from the aperture 20a toward the front side of the main body 12 (i.e., toward the left side in the drawing). As shown in **FIG. 6****,** the aperture 20a is formed at a position in which the other segment 19b of the engagement piece 19 is loosely fitted thereinto when the cover 13 is positioned at its retracted position. Also, the slit 20b is in a state in which it is engaged with the engagement groove defined by the other segment 19b of the engagement piece 19 to allow the cover 13 to be engaged with the main body 12 when the cover 13 is positioned at its advanced position as shown in **FIG. 5****.**

Under the above construction, in a normal use state, the cover 13 is positioned in the advanced position with respect to the main body 12, and the cover rear surface portion 13a joins with the main body rear surface portion 12a as shown in **FIGS. 1****,** **2** **and** **5**. As shown in **FIG. 2****,** the power cord 15 is connected to the power inlet 16 of the main body 12 via the through part 17 formed on the cover rear surface portion 13a to supply power to the inside of the main body 12. In addition, at this time, as shown in **FIG. 5****,** the other segment 19b of the engagement piece 19 provided on the inner surface of the cover side surface portion 13b is engaged with the slit 20b of the engagement part 20, so that the cover 13 is integrally engaged with the main body 12. For this reason, the cover 13 can be fixed to the main body 12, e.g., only by one screw 18, that is secured between the cover rear surface portion 13a and the main body rear surface 12a as shown in **FIG. 1****.**

When removing the cover 13 from the main body 12 for the purpose of repair and maintenance, one screw is first released. Thereafter, the cover 13 is moved slidably in the direction of an arrow "B" (i.e., in the first direction) shown in **FIGS. 1** **and** **5****.** The sliding movement of the cover 13 allows the engagement pieces 19 that are positioned in an engaged state in the slits 20b as shown in **FIG. 5** to be moved to the right side of the drawing, so that the engagement pieces 19 are finally positioned in the apertures 20a of the engagement parts 20 as shown in **FIGS. 6** **and** **7****.** As described above, since the aperture 20a has an area sized to allow the other segment 19b of the engagement piece 19 to be loosely fitted thereinto, both sides of the cover 13 is opened slightly outwardly at a lower portion thereof, so that the engagement piece 19 can be disengaged from the aperture 20a, and the cover 13 is lifted in the direction of the arrow "C" (i.e., in the second direction orthogonal to the first direction) as shown in **FIGS. 1****,** **4** **and** **7** so that the cover 13 can be removed from the main body 12.

However, when the power cord 15 has been connected to the power inlet 16 of the main body 12 as shown in **FIGS. 3** **and** **4****,** since the power cord 15 passes through the through part 17 formed on the cover rear surface portion 13a, the power cord 15 impedes the cover 13 from moving in the direction of the arrow "C" (i.e., in the second direction). Accordingly, in a state in which the power cord 15 is connected to the power inlet 16 to apply electric power to electronic instruments in the main body 12, the cover 13 is prevented from being open, thereby making it possible, in some embodiments, for a maintenance worker to surely avoid an accident involving an electric shock thereby improving safety levels and preventing damage of the electronic instruments.

Moreover, the mounting process of the cover 13 on the main body 12 is performed in a reverse manner to the aforementioned removal process thereof. That is, the cover 13 is moved in the direction opposite to the direction of the arrow "C," and then the engagement pieces 19 provided on the inner surface of the cover side surface portion 13b is fitted into the apertures 20a of the engagement parts 20 formed on the main body side surface portion 12b. Such fitting operation is easily performed, e.g., by using elasticity of the engagement pieces 19 and the cover side surface portion 13b. Thereafter, the cover 13 is moved in the direction of the arrow "A" shown in **FIG. 1** so that the engagement pieces 19 are slid along the slits 20b to be engaged with the slits 20b as shown in **FIG. 5****.** The sliding movement of the cover 13 allows the cover 13 to be integrally engaged with the case of the main body 12. Then, one screw 18 shown in **FIG. 1** is tightened so that the cover 13 is fixedly attached to the case of the main body 12. Also, the power cord 15 is inserted into the power inlet 16 mounted on the main body rear surface portion 12a via the through part 17 formed on the cover rear surface portion 13a as shown in **FIG. 2** so that electric power is supplied to electronic parts 14 mounted inside the main body 12 to put the electronic parts into an operable state.

In this manner, the cover 13 is moved in two directions that are substantially orthogonal to each other so that the cover 13 can be integrally engaged with the main body or can be released from the engaged state. Thus, only one screw 18 for fixing the cover need to be processed. As a result, since the cover does not need to be fixed to the main body by using a plurality of screws unlike the related art, the attachment and detachment of the cover to and from the main body is facilitated. Further, in case of removing the cover 13 from the main body 12, the removal of the cover 13 is impeded in a state in which the power cord 15 has been connected to the power inlet, thereby preventing a maintenance worker from suffering from an electric shock thereby improving safety levels.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the inventions. The accompanying claims and their equivalents are intended to cover such forms or modifications as would fall within the scope of the inventions.

## Claims

1. A cover detaching and attaching structure to allow a cover (13) including a through part (17), through which a power cord (15) connected to a connection part (16) passes, to be integrally engaged with a main body (12) comprising the connection part (16) for the power cord (15) and to be removed from the main body (12) in a state in which the power cord (15) has passed through the through part (17),
wherein the cover detaching and attaching structure is arranged between the main body (12) and the cover (13), to allow the cover (13) to move in a first direction (B) along the longitudinal direction of the power cord (15) connected to the connection part (16) from a state of being integrally engaged with the main body (12), and
wherein the cover (13) is further allowed to move in a second direction (C) orthogonal to the first direction (B), thereby being detached from the main body (12), the second direction (C) being a direction in which the movement of the cover (13) is impeded by interference of the power cord (15) connected to the connection part (16).

2. The structure of Claim 1, comprising one or more engagement pieces (19) formed on an inner side surface of the cover (13), and one or more engagement parts (20) formed on a side surface of the main body (12), the engagement piece respectively engaged with the one or more engagement parts (20).

3. The structure of Claim 2, wherein at least one of the one or more engagement pieces (19) comprises a first segment (19a) that is integrally joined to the inner side surface of the cover (13), and a second segment (19b) that defines an engagement groove between the first segment (19a) and the inner surface of the cover (13).

4. The structure of Claim 3, wherein at least one of the one or more engagement parts (20) comprises an aperture (20a) and a slit (20b) extending from the aperture (20a) toward the front side of the main body (12).

5. The structure of Claim 4, wherein the aperture (20a) is formed at a position in which the second segment (19b) of the at least one of the one or more engagement pieces (19) is loosely fitted thereinto when the cover (13) is moved in the first direction (B).

6. The structure of Claim 4, wherein the slit (20b) is engaged with the engagement groove defined by the second segment (19b) of the at least one of the one or more engagement pieces (19) to allow the cover (13) to be engaged with the main body (12).

7. The structure of Claim 4, wherein the cover (13) is moved in the first direction (B) until the at least one of the one or more engagement pieces (19) is positioned in the aperture (20a) of the engagement part (20).

8. The structure of Claim 2, wherein the at least one of the one or more engagement pieces (19) has a Z-shape in cross section.

9. The structure of Claim 2, wherein a spacing of the engagement groove is set to be slightly larger than the thickness of a side surface of the main body (12).

10. The structure of Claim 1, wherein the power cord (15) comprises a plug unit having a structure to limit the range of movement in the first direction (B).

11. A cover detaching method to allow a cover (13) including a through part (17), through which a power cord (15) connected to a connection part (16) passes, to be integrally engaged with a main body (12) including the connection part (16) for the power cord (15) and to be removed from the main body (12) in a state in which the power cord (15) has passed through the through part (17), the method comprising:
moving the cover (13) in a first direction (B) along the longitudinal direction of the power cord (15) connected to the connection part (16) from a state of being integrally engaged with the main body (12); and
moving the cover (13) in a second direction (C) orthogonal to the first direction (B), thereby being detached from the main body (12), the second direction (C)being a direction in which the movement of the cover (13) is impeded by interference of the power cord (15) connected to the connection part (16).
